# EUROPÄISCHE PATENTSCHRIFT

(11) **EP 3 059 828 B1**
(45) Veröffentlichungstag und Bekanntmachung des Hinweises auf die Patenterteilung: **04.08.2021**
(21) Anmeldenummer: 15182875.3
(22) Anmeldetag: 28.08.2015
(51) Int. Cl.: H02H 3/33, H02H 3/16, H02H 7/12, G01R 19/10, H02H 5/12

(54) **VORRICHTUNG UND VERFAHREN ZUR FEHLERSTROMDETEKTION**
DEVICE AND METHOD FOR DETECTING RESIDUAL CURENT
DISPOSITIF ET PROCEDE DE DETECTION DE COURANT DIFFERENTIEL

(30) Priorität: 20.02.2015 DE 102015102485
(43) Veröffentlichungstag der Anmeldung: 24.08.2016
(73) Patentinhaber: ebm-papst Mulfingen GmbH & Co. KG, 74673 Mulfingen (DE)
(72) Erfinder: Haas, Günter, 74673 Mulfingen (DE); Lipp, Helmut, 74677 Dörzbach-Hohebach (DE)
(74) Vertreter: Staeger & Sperling Partnerschaftsgesellschaft mbB

(56) Entgegenhaltungen:
- WO-A1-2008/024068
- CN-A- 103 779 833
- DE-A1- 2 819 204
- DE-A1-102011 016 539
- US-A1- 2012 112 757

## Beschreibung

Die vorliegende Erfindung bezieht sich auf einen EC-Motor gemäß den Merkmalen von Anspruch 1 sowie auf ein Verfahren zum Erfassen von Fehlerströmen gemäß Anspruch 8.

Es ist in elektrischen Anlagen und bei EC-Gleichstrommaschinen erforderlich einen Fehlerstrom sicher detektieren zu können. Die spektrale und phasenrichtige Erfassung von Absolut- und Relativströmen ist zur Gefahreneinschätzung von Fehlerströmen und für die Beurteilung des Gefährdungspotentials von Fehlerströmen für Mensch und Material essentiell.

Als Fehlerstrom wird ein elektrischer Strom bezeichnet, der aufgrund eines Isolationsfehlers über eine gegebene Fehlerstelle fließt. Zur Berechnung der Fehlerstromstärke müssen, je nach Art des Fehlers und Fehlerort, die Widerstände des Transformators, der Leiterwiderstand, Erdungswiderstände, Körperwiderstände, der Widerstand des die Fehlerstelle berührenden Menschen und ggf. weitere Übergangswiderstände berücksichtigt werden. In der Elektroinstallationstechnik wird die Einschätzung des Gefährdungspotentials durch eine elektrische Anlage auf der Basis von Momentanwerten der zu überwachenden Ströme in dem Wechselstromnetz durchgeführt. Dies gilt sowohl für Absolutwerte als auch für Relativ- und/oder Differenzwerte der zu überwachenden Ströme, wobei diese Stromwerte auch als Fehlerstrom bezeichnet werden. Diese Art der Gefahrenerkennung wird in Form von Fehlerstromschutzschaltern, die auch als FI-Schalter bezeichnet werden und die den Differenzstrom zwischen einem Hin- und einem Rückleiter messen, eingesetzt.

Sofern in dem betreffenden Stromkreis ein solcher Fehlerstromschutzschalter (kurz: FI-Schutzschalter) installiert ist und der nötige Bemessungsdifferenzstrom erreicht wird, schaltet der Schutzschalter den Stromkreis allpolig ab.

Im Stand der Technik sind unterschiedlichste Verfahren zur Beurteilung des Gefährdungspotentials durch Fehlerströme für Mensch und Material beschrieben. Die Patentschrift DE 196 34 438 A1 beschreibt beispielsweise eine Fehlerstromschutzeinrichtung oder Differenzstromschutzeinrichtung zum Schutz gegen gefährliche Körperströme. Die Schutzeinrichtung zum Schutz gegen Fehlerströme soll mit variabler Frequenz in ihrem Auslöseverhalten auf Auslösewerte hinsichtlich eines Frequenzfaktors F als Quotient aus zulässigem Körperstrom für den Menschen bei variabler Frequenz des Fehlerstroms und zulässigem Körperstrom bei 50 Hz bzw. 60 Hz und hinsichtlich der Frequenz f des Fehlerstroms unterhalb einer Grenzkurve nach einem vorgegebenen Diagramm abgestimmt sein.

Aus der DE 10 2011 016 539 A1 ist eine Ladevorrichtung zum Laden einer Batterie bekannt, die mit einem FI-Schalter ausgebildet ist. Aus der DE 2819204 A ist eine Schaltungsanordnung für gleich- und/oder wechselstromsensitive mit einem Verstärker versehene FI-Schutzschaltung bekannt.

Aus der DE 102007027727 A1 ist eine Vorrichtung zur Erfassung von Fehlerströmen in elektrischen Schaltkreisen bei Maschinen bekannt, wobei wenigstens ein elektrischer Schaltkreis in der Maschine ein elektromagnetisches Filter aufweist und wobei das elektromagnetische Filter mit einer Messvorrichtung zur Erfassung eines Fehlerstroms verbunden ist.

Weiterer druckschriftlicher Stand der Technik im vorliegenden technischen Gebiet, welcher den Oberbegriff des Anspruchs 1 widerspiegelt, ist in den Dokumenten WO 2008/024068 A1 und US 2012/112757 A1 offenbart.

Bei Verwendung von elektronisch kommutierten Gleichstrommaschinen stellt sich die Frage nach der Verwendung des passenden FI-Schutzschalters. Die Auswahl des FI-Schutzschalters hängt im Wesentlichen von der Stromform eines eventuell auftretenden Fehlerstromes ab. Es gibt unterschiedliche Typen von Fehlerstromschutzschaltern, die je nach Art des Fehlerstroms, den sie erfassen können, einem bestimmten Typ zugeordnet sind.

Fehlerstromschutzschalter des Typs AC erfassen nur rein sinusförmige Fehlerströme und sind nach der derzeit gültigen VDE 0100-530 in Deutschland nicht mehr als Fehlerstromschutz-Einrichtung zugelassen.

Fehlerstromschutzschalter vom Typ A umfassen die handelsüblichen, pulsstromsensitiven Fehlerstromschutzeinrichtungen. Mit diesem Typ sind sowohl rein sinusförmige Wechselströme als auch pulsierende Gleichfehlerströme detektierbar. Die erforderliche Empfindlichkeit wird durch spezielle Magnetwerkstoffe für die eingesetzten Ringbandkerne und Resonanzschaltungen zur Beeinflussung des Frequenzgangs erreicht. Pulsstromsensitive Fehlerstromschutzeinrichtungen arbeiten netzspannungsunabhängig.

Fehlerstromschutzschalter vom Typ F sind mischfrequenzsensitive FehlerstromSchutzeinrichtungen und erfassen demzufolge auch alle Fehlerstromarten wie beim Typ A. Darüber hinaus sind sie zur Erfassung von Fehlerströmen, die aus einem Frequenzgemisch von Frequenzen bestehen, verwendbar. Somit ist es möglich die Fehlerstromformen auf der Ausgangsseite von einphasig angeschlossenen Frequenzumrichtern zu erfassen.

Fehlerstromschutzschalter vom Typ B sind allstromsensitive Fehlerstromschutzschalter, welche neben Wechselfehlströmen auch glatte Gleichfehlströme erfassen können. Diese Fehlerstromschutz-Einrichtungen enthalten einen zweiten Summenstromwandler und eine integrierte Elektronikeinheit. Die Überwachung mit einem Fehlerstromschutzschalter vom Typ B auf Gleichfehlerströme erfordert jedoch eine eigene Stromversorgung. Der Betrieb und Einsatz ist somit netzspannungsabhängig. Der wechsel- bzw. pulsstromsensitive Schalterteil ist davon unabhängig und arbeitet wie bei Typ A netzspannungsunabhängig.

Der Einsatz von Typ B ist insbesondere bei Wechselrichtern und Frequenzumrichtern, welche im Bereich des Zwischenkreises mit Gleichrichtern arbeiten, üblich.

Ein essentielles Element eines Fehlerstromschutzschalters ist dabei der sogenannte Summenstromwandler durch den alle stromführenden Leiter einschließlich des Nulleiters gleichsinnig und miteinander hindurch geführt werden. Normale und bestimmungsgemäße Betriebsströme haben auf diesen Summenstromwandler keine Wirkung, da aus der Summe kein Differenzstrom hervorgeht.

Sobald jedoch ein Fehlerstrom aus dem geschlossenen Stromkreis zum Massepotential abfließt, wird das elektromagnetische Gleichgewicht des Wandlers um den Betrag des nach Masse fließenden Fehlerstroms gestört. Der Wandler wird infolgedessen magnetisiert und bewirkt augenblicklich über einen hochempfindlichen Auslöser die allpolige Ausschaltung des Fehlerstromschutzschalters.

Fehlerstromschutzschalter des Typs A messen also den Wechselstromanteil des Fehlerstroms, wobei der Gleichstromanteil des Fehlerstroms nicht erfasst wird und deshalb auch nicht bewertet werden kann

Bisher sind nur FI-Schutzschalter des Typs B beim Einsatz elektronisch kommutierten Geräte bekannt. Neben den Geräten mit passiver PFC-Stufe, haben sich Geräte mit aktiver PFC-Stufe erst in der jüngsten Vergangenheit im Markt verbreitet. Bei Gebäudeinstallationen werden überwiegend FI-Schutzschalter des Typs A eingebaut. Dass diese FI-Schutzschalter bei Geräten mit aktiver PFC-Regelung Fehlerströme ggf. nicht erkennen und daher wahrscheinlich nicht auslösen werden, ist dabei nachteilig und gefährlich.

Die im Stand der Technik bekannten Methoden lassen sich aber nicht bei elektronisch kommutieruten Gleichstrommaschinen mit einer aktiven PFC-Regelung und geboosteter Zwischenkreisspannung unter Beachtung der einschlägigen Normen und Vorschriften in der Installationstechnik einsetzen. Es ist bei diesen Geräten nicht möglich einen Fehlerstromschutzschalter (FI-Schutzschalter) des Typs A zu verwenden. Durch die geboostete Spannung fließt im Fehlerfall (z. B. bei defekter Isolation) ein Gleichstrom, den ein FI-Schutzschalter des Typs A (wie oben näher erläutert) nicht abschalten kann.

Nachteilig ist insofern, dass nicht die herkömmlichen und wesentlich günstigeren FI-Schutzschalter des Typs A verwendet werden können, sondern die um ein Vielfaches teureren FI-Schutzschalter des Typs B.

Die Aufgabe der vorliegenden Erfindung besteht darin, vorbesagten Nachteil zu überwinden und eine Lösung für Zwischenkreise mit aktiver PFC-Regelung und geboosteter Spannung vorzusehen, deren Fehlerströme dennoch zuverlässig und sicher mit einem FI- Schutzschalter des Typs A betrieben werden können.

Eine weitere Aufgabe der vorliegenden Erfindung besteht darin eine Lösung vorzusehen, die eine zulässige maximale Abschaltzeit zum Auslösen des FI-Schalters gemäß den einschlägigen VDE- Installationsnormen und Errichterbestimmungen gewährleistet.

Diese Aufgabe wird durch eine Vorrichtung gemäß den Merkmalen des Anspruchs 1 sowie einem Verfahren gemäß den Merkmalen des Anspruchs 8 gelöst.

Grundgedanke der vorliegenden Erfindung ist es dabei, eine Abschaltbedingung für die aktive Leistungsfaktorkorrektur aus den Stromsignalen in der Hin- und Rückleitung (d. h. den stromführenden Leitern) zu der Kommutierungsschaltung dann zu erzeugen, wenn sich aus dem Betrag eines zu den Stromsignalen proportionalen Differenzsignals ergibt, dass ein Fehlerstrom oberhalb einer maximal zulässigen Grenze im System vorhanden ist. Hierdurch wird erreicht, dass sich die Kurvenform des Fehlerstroms ändert und eine Form aufweist, die von einem FI-Schalter des Typs A erkannt wird.

Erfindungsgemäß wird demnach eine Vorrichtung zum Erfassen von Fehlerströmen in einem geregeltem Gleichspannungszwischenkreis mit einer aktiven Leistungsfaktorkorrektur (PFC) bereitgestellt, die folgendes aufweist:
- eine Erfassungseinrichtung zum Erfassen von Strömen S1, S2 (Stromsignale), die durch die beiden eingangsseitigen stromführenden Leiter (Hin- und Rückleitung) fließen,
- einen Wandler zum Erzeugen jeweils eines analogen Signals S1', S2' aus dem jeweils erfassten Signalen S1, S2,
- einen Differentialverstärker zum Verstärken und/oder Aufbereiten eines Signals S_{DIFF} als Differenzsignal aus den Signalen S1', S2', wobei das Differenzsignal korrespondierend zu einem detektierten Fehlerstrom oberhalb eines maximal zulässigen Schwellenwertes des Signals S_{DIFF} ist (schaltet PFC, wodurch U_{ZWR} reduziert wird) und
- eine Schaltungsanordnung zum (aktiven) Absenken der Zwischenkreisspannung, so dass das Signals S_{DIFF} von einem FI-Schutzschalter des Typs A zum Abschalten genutzt werden kann.

So gelingt es in erfinderischer Weise, dass auch eine Kommutierungsschaltung gespeist aus einem Gleichspannungszwischenkreis mit einer aktiven Leistungsfaktorkorrektur und ggf. einer geboosteten Spannung mit einem FI-Schutz-schalter des Typs A zur Fehlerstromerfassung betrieben werden kann.

In einer besonders bevorzugten Ausführungsform der Erfindung ist vorgesehen, dass das Absenken der Zwischenkreisspannung durch das Abschalten der aktiven Leistungsfaktorkorrektur bewerkstelligt wird. Dadurch sinkt die Zwischenkreisspannung zwischen U_{ZWK+} und dem Massepotential (bzw. dem Schutzleiteranschluss) und die Kurvenform der Fehlerstromkurve verändert sich in eine vom FI-Typ A erfassbaren Kurvenform, die dem Verlauf einer Fehlerstromkurve entsprechend einer Kommutierungselektronik mit passiver Leistungsfaktorkorrektur ist. D.H. aufgrund der Änderung des Spannungsverlaufs der Spannung ändert sich auch der Verlauf des Fehlerstroms entsprechend, der sodann von einem FI-Schutzschalter des Typs A erkannt und der Fehlerstrom sicher abgeschaltet werden kann.

Es ist bevorzugt vorgesehen, dass die Erfassungseinrichtung je ein elektrisches Bauelement in jedem der beiden stromführenden Leitern zum Abgriff von Signalen, insbesondere von Stromsignalen (I_{zu}, I_{rück}) aufweist. Besonders bevorzugt ist eine Ausgestaltung, bei der die beiden elektrischen Bauelemente (3a, 3b) paarweise entweder Widerstände, Induktivitäten oder Magnetfeldsensoren darstellen.

In einer weiter vorteilhaften Ausgestaltung der Erfindung ist vorgesehen, dass Differentialverstärker z. B. ein Signalaufbereitungsmodul umfasst das ausgebildet ist, das Differenzsignal S_{DIFF} so aufzubereiten, dass es von einem Micro-Controller, einem ASIC, einem integrierten Schaltkreis oder dergleichen weiterverarbeitet werden kann. Es ist insoweit vorteilhaft, wenn die Schaltungsanordnung einen Micro-Controller, einen ASIC oder einen integrierten Schaltkreis zur Verarbeitung des Signals S_{DIFF} aufweist.

Ein weiterer Aspekt der vorliegenden Erfindung betrifft ein Verfahren zum Erfassen von Fehlerströmen gemäß einer wie zuvor beschriebenen Vorrichtung, wobei
- die Erfassungseinrichtung zwei Signale S1, S1, die jeweils proportional zu den Strömen sind, die beim Betrieb der Vorrichtung durch die beiden eingangsseitigen stromführenden Leiter (d.h. durch die Hinleitung und Rückleitung) fließen,
- Erzeugen jeweils eines vorzugsweise analogen Signals S1', S2' aus den erfassten Signalen S1, S1,
- Aufbereiten eines Signals S_{DIFF} als Differenzsignal aus den Signalen S1', S2' korrespondierend zu einem detektierten Fehlerstrom und
- Absenken der Zwischenkreisspannung, so dass das Signals S_{DIFF} so dass das Signals S_{DIFF} von einem FI-Schutzschalter des Typs A zum Abschalten genutzt werden kann, sofern der Fehlerstrom oberhalb eines maximal zulässigen Schwellenwertes liegt.

Besonders vorteilhaft ist eine Ausführung des Verfahrens, wenn mittels des aktiven Absenkens der Zwischenkreisspannung der Spannungsverlauf zwischen der Zwischenkreisspannung und dem Massepotential so erfolgt, dass ein Abschalten des PFCs erfolgt. Dies kann in vorteilhafter Weise dadurch erfolgen, dass die Zwischenkreisspannung durch das Abschalten der aktiven Leistungsfaktorkorrektur abgesenkt wird.

Dies erfolgt bevorzugt nur dann, wenn wie oben angegeben, der Fehlerstrom oberhalb eines definierten Schwellenwertes liegt. Zeigt demzufolge das Differenzsignal einen Betrag oberhalb eines Schwellenwertes, wird die aktiven Leistungsfaktorkorrektur ausgeschaltet oder überbrückt.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt.

Es zeigen:
- Fig.1: ein Prinzipschaltbild einer bekannten Kommutierungselektronik für einen 3-strängigen EC-Motor mit einer passiven PFC;
- Fig.2: ein Prinzipschaltbild einer bekannten Kommutierungselektronik für einen 3-strängigen EC-Motor mit einer aktiven PFC;
- Fig.3: CH4 den Spannungsverlauf zwischen der Zwischenkreisspannung und dem Schutzleiterpotential bei einem Inverter mit passiver PFC, CH2 zeigt die Netzeingangsspannung;
- Fig.4: CH4 den Spannungsverlauf zwischen der Zwischenkreisspannung und dem Schutzleiterpotential bei einem Inverter mit aktiver PFC, CH2 zeigt die Netzeingangsspannung;
- Fig.5: CH4 den Spannungsverlauf zwischen der Zwischenkreisspannung und dem Schutzleiterpotential bei einem Zwischenkreis einer Kommutierungsschaltung mit passiver PFC und CH3 zeigt den Fehlerstrom, CH2 die Eingangsspannung;
- Fig.6: CH4 den Spannungsverlauf zwischen der Zwischenkreisspannung und dem Schutzleiterpotential bei einem Zwischenkreis einer Kommutierungsschaltung mit aktiver PFC und CH3 zeigt den Fehlerstrom, CH2 die Eingangsspannung und
- Fig.7: ein Prinzipschaltbild eines Ausführungsbeispiels der Erfindung einer Kommutierungselektronik für einen EC-Motor mit einer aktiven PFC.

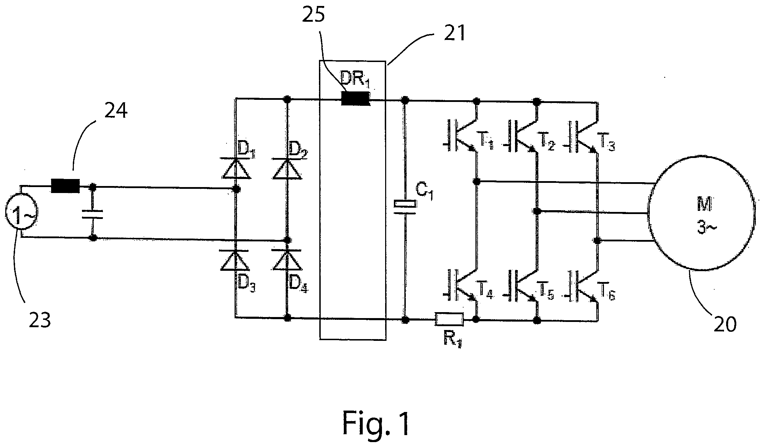

In der folgenden Beschreibung anhand der Figuren 1 bis 7 weisen gleiche Bezugszeichen auf gleiche strukturelle oder funktionale Merkmale hin. Die Figur 1 zeigt das Prinzipschaltbild einer Kommutierungselektronik mit passivem PFC 21 für einen dreisträngigen EC-Motor 20, der eingangsseitig mit einer Wechselspannungsquelle 23 über ein EMV-Filter 24, bestehend aus einer L-C Kombination verbunden ist. Die passive Leistungsfaktorkorrektur 21 besteht hier lediglich aus einer Zwischenkreisdrossel 25.

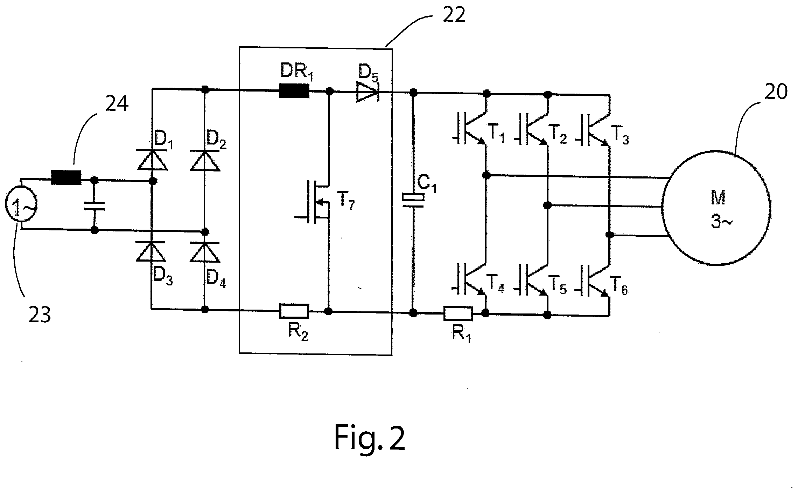

In der Figur 2 ist eine Kommutierungselektronik mit einer aktiven Leistungsfaktorkorrektur 22 dargestellt. Bei einer Elektronik mit passivem PFC nach Fig.1 liegt die Zwischenkreisspannung, die über dem Kondensator C₁ anliegt, bei einem Wert von U_{c1} = √2 * U_{ac}, wobei U_{ac} die Speisewechselspannung ist. Mit einer Kommutierungsschaltung mit einem aktiven PFC, wie in Figur 2 dargestellt, kann die Spannung über dem Kondensator C₁ auf Werte von U_{ZWK} > √2 * U_{ac,rms} eingestellt werden. Typische Werte, die in EC-Geräten verwendet werden liegen bei Spannungen im Bereich von 380VDC bis 440VDC.

Zwischen dem positiven Anschluss des Kondensators (Anode) und dem PE-Potential (Schutzleiterpotential) liegt demzufolge eine Spannung an, die je nach Topologie, wie in den nachfolgend beschriebenen Figuren gezeigt, aussieht.

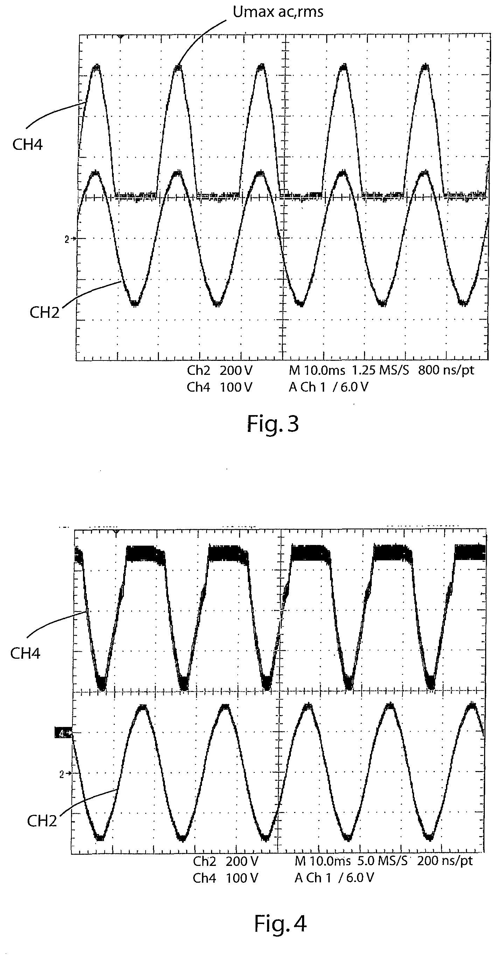

Die Fig.3 zeigt den Spannungsverlauf zwischen der Zwischenkreisspannung und dem Schutzleiterpotential bei einem Inverter mit passiver PFC und die Fig.4 den Spannungsverlauf zwischen der Zwischenkreisspannung und dem Schutzleiterpotential bei einem Inverter mit aktiver PFC.

Gezeigt sind Messkurven, die entsprechenden Messkanälen zugeordnet sind. Die sinusförmige Eingangsspannung der Wechselspannungsquelle ist in der unteren Kurve auf dem Kanal Ch2 dargestellt. Der Spannungsverlauf zwischen der Zwischenkreisspannung und dem Schutzleiterpotential ist in Kanal Ch4 für einen Inverter mit passiver PFC gezeigt. Es ist deutlich zu erkennen, dass das Potential zwischen der Zwischenkreisspannung und dem Schutzleiterpotential d.h. der Spannung U_{ZWK+} gegenüber dem Schutzleiterpotential (PE-Potential) zwischen den Werten 0V und U_{max ac,rms} wechselt.

Zum Vergleich zeigt die Fig.4 den Spannungsverlauf zwischen der Zwischenkreisspannung und dem Schutzleiterpotential bei einem Inverter mit aktiver PFC. Hierbei ist das Spannungspotential zwischen der Anode des Kondensators und dem Schutzleiterpotenial immer größer OV. Der minimale Wert liegt bei Uₘᵢₙ=U_{ZWK-ac,rms}.

Liegt in den genannten Beispielen ein Isolationsfehler in der Schaltung vor, so enstpricht dies topologisch einem Zustand bei dem ein Widerstand zwischen dem positiven Zwischenkreispotential und dem Schutzleiter(PE)-Potential eingebracht wird. Entsprechend dem Spannungsverlauf verhält sich dann auch der Fehlerstrom. Bei dem Inverter gemäß der Figur 1 wird der Strom periodisch bis auf 0A und bei dem Inverter gemäß der Figur 2 auf einen Minimalwert zurückgehen, der den minimalen Fehlerstrom darstellt, wobei dieser sich aus dem Quotienten (U_{zwk} - √2 * U_{ac,rms}) / R_{Fehler} ermittelt. Im Gegensatz zum Inverter gemäß der Figur 1 fließt bei dem Inverter gemäß der Figur 2 immer ein Gleichstromanteil.

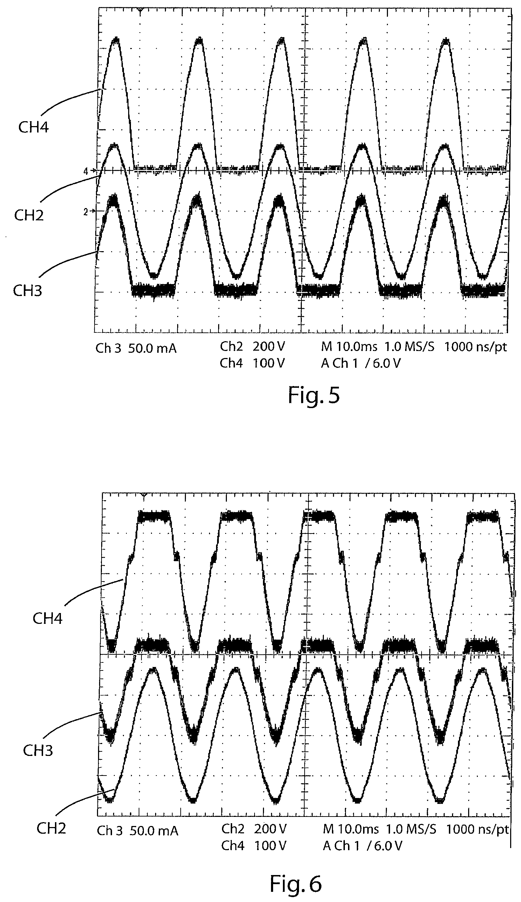

In den Figuren 5 und 6 ist jeweils eine Situation dargestellt, bei der bei den beiden Schaltungstopologien jeweils ein Widerstand von R_{Fehier} von 3 KΩ zwischen der Zwischenkreisspannung und dem Schutzleiterpotential (hier das leitende Gehäuse des Motors) eingebaut wurde.

Die Fig.5 repräsentiert die Messergebnisse bei einer Kommutierungselektronik mit passiver PFC. In der oberen Kurve (CH4) ist der Spannungsabfall über den Fehlerwiderstand R_{Fehier} aufgetragen. In der unteren Kurve (CH3) ist der korrespondierende Fehlerstrom dargestellt, der über den Widerstand zum Gehäuse abfließt.

In Fig. 6 sind die Messkurven einer entsprechenden Messung für den Fall bei Verwendung einer Kommutierungselektronik mit aktiver PFC gezeigt. In diesen Abbildungen stellt die mittlere sinusförmige Messkurve (Kanal Ch2) die sinusförmige Eingangsspannung dar. Die Spannung zwischen U_{ZWK+} und dem Schutzleiterpotential wird durch die obere Kurve (Ch4) widergegeben und der gemessene Fehlerstrom durch den Widerstand R_{Fehler} wird durch die mittlere Kurvenform dargestellt.

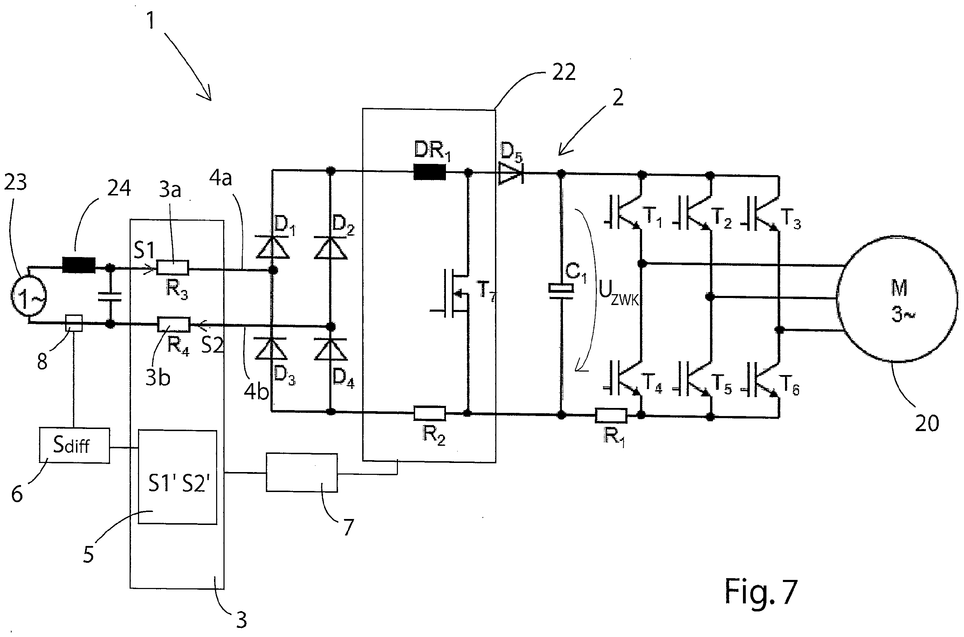

Die Figur 7 zeigt ein Prinzipschaltbild eines Ausführungsbeispiels der Erfindung einer Kommutierungselektronik für einen EC-Motor mit einer aktiven PFC. Gezeigt ist eine Vorrichtung 1 zum Erfassen von Fehlerströmen in einem geregeltem Gleichspannungszwischenkreis 2 mit einer aktiven Leistungsfaktorkorrektur 22 und mit einer Erfassungseinrichtung 3 zum Erfassen von Stromsignalen S1, S2, die durch die beiden eingangsseitigen stromführenden Leitern 4a, 4b fließen.

Die Erfassungseinrichtung 3 weist je ein elektrisches Bauelement 3a, 3b in jedem der beiden stromführenden Leitern 4a, 4b zum Abgriff von Stromsignalen S1=I_{zu} und S2=I_{rück} auf, somit die Ströme durch die Hinleitung und die Rückleitung. Mit den weiter unter beschriebenen Erfassungsmöglichkeiten wird der erfasste Stromwert aus der Hinleitung und Rückleitung in ein entsprechendes analoges Spannungssignal umgewandelt. Diese Spannungssignale werden bevorzugt einem Differenzialverstärker 6 als Eingangssignale zugeführt.

Ein Wandler 5 ist zum Erzeugen jeweils eines analogen Signals S1', S2' aus dem jeweils erfassten Signalen S1, S2 vorgesehen, sowie ein Differentialverstärker 6 zum Aufbereiten eines Signals S_{DIFF} als Differenzsignal zwischen den Signalen S1', S2' korrespondierend zu einem detektierten Fehlerstrom, insbesondere für den Fall, dass der Fehlerstrom oberhalb eines maximal zulässigen Schwellenwertes des Signals S_{DIFF} liegt.

Zum Absenken der Zwischenkreisspannung ist eine Schaltungsanordnung 7 vorgesehen, so dass mittels des Signals S_{DIFF} Ein Abschaltprozess initiiert werden kann. Die Schaltungsanordnung 7 ist so ausgebildet, dass das Absenken der Zwischenkreisspannung durch das Abschalten der aktiven Leistungsfaktorkorrektur erfolgt.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht. So können die Erfassungseinrichtung 3, der Wandler 4 und/oder die Schaltungsanordnung 7 auch als gemeinsame Schaltung ausgebildet sein.

## Patentansprüche

1. EC-Motor (20) mit einem geregeltem Gleichspannungszwischenkreis (2) bestehend aus einem Gleichrichter, einem Zwischenkreiskondensator und einem Wechselrichter und einer Kommutierungselektronik mit einer aktiven Leistungsfaktorkorrektur (22) zum Erfassen von Fehlerströmen in dem Gleichspannungszwischenkreis (2), wobei der Gleichspannungszwischenkreis (2) zwei eingangsseitige stromführende Leiter (4a, 4b) aufweist, umfassend:
a. eine Erfassungseinrichtung (3) zum Erfassen von Signalen (S1, S2), die jeweils proportional zu den Strömen sind, die durch die beiden eingangsseitigen stromführenden Leitern (4a, 4b) fließen,
b. einen Wandler (5) zum Erzeugen jeweils eines analogen Signals (S1', S2') aus dem jeweils erfassten Signalen (S1, S2),
c. einen Differentialverstärker (6), der mit der Erfassungseinrichtung (3) so verbunden ist, dass die analogen Signals (S1', S2') dem Differenzialverstärker (6) als Eingangssignale zugeführt werden, zum Aufbereiten eines Signals S_{DIFF} als Differenzsignal zwischen den Signalen (S1', S2') korrespondierend zu einem detektierten Fehlerstrom in der Kommutierungselektronik,
d. **dadurch gekennzeichnet, dass** eine Schaltungsanordnung (7) zwischen der aktiven Leistungsfaktorkorrektur (22) und der Erfassungseinrichtung (3) zum Absenken der Zwischenkreisspannung angeordnet ist, so dass das Signals S_{DIFF} von einem FI-Schutzschalter (8) des Typs A zum Abschalten erfasst werden kann.

2. EC-Motor (20) gemäß Anspruch 1, **dadurch gekennzeichnet, dass** die Schaltungsanordnung (7) so ausgebildet ist, dass das Absenken der Zwischenkreisspannung durch das Abschalten der aktiven Leistungsfaktorkorrektur erfolgt.

3. EC-Motor (20) gemäß Anspruch 1 oder 2, **dadurch gekennzeichnet, dass** der Gleichspannungszwischenkreis (2) zur Erzeugung einer geboosteten Zwischenkreisspannung ausgebildet ist.

4. EC-Motor (20) gemäß einem der vorhergehenden Ansprüche, **dadurch gekennzeichnet, dass** die Erfassungseinrichtung (3) je ein elektrisches Bauelement (3a, 3b) in jedem der beiden stromführenden Leiter (4a, 4b) zum Abgriff von Stromsignalen (I_{zu}, I_{rück}) aufweist.

5. EC-Motor (20) gemäß Anspruch 4, **dadurch gekennzeichnet, dass** die beiden elektrischen Bauelemente (3a, 3b) paarweise entweder Widerstände, Induktivitäten oder Magnetfeldsensoren darstellen.

6. EC-Motor (20) gemäß einem der vorhergehenden Ansprüche, **dadurch gekennzeichnet, dass** der Differentialverstärker (6) ein Signalaufbereitungsmodul umfasst, um das Signal S_{DIFF} so aufzubereiten, dass es von einem Micro-Controller, einem ASIC oder einem integrierten Schaltkreis weiterverarbeitet werden kann.

7. EC-Motor (20) gemäß einem der vorhergehenden Ansprüche, **dadurch gekennzeichnet, dass** die Schaltungsanordnung (7) einen Micro-Controller, einen ASIC oder einen integrierten Schaltkreis zur Verarbeitung des Signals S_{DIFF} aufweist.

8. Verfahren zum Erfassen von Fehlerströmen mit einem EC-Motor (20) nach einem der Ansprüche 1 bis 7, wobei
a. Erfassen zweier Signale (S1, S2), die jeweils proportional sind zu den Strömen die beim Betrieb der Vorrichtung durch die beiden eingangsseitigen stromführenden Leitern (4a, 4b) fließen,
b. Erzeugen jeweils eines analogen Signals (S1', S2') aus den erfassten Signalen (S1, S2),
c. Zuführen der analogen Signale (S1', S2') an den Differentialverstärker (6), der mit der Erfassungseinrichtung (3) so verbunden ist, dass die analogen Signals S2') dem Differenzialverstärker (6) als Eingangssignale zugefürhrt werden, zum Aufbereiten eines Signals S_{DIFF} als Differenzsignal zwischen den Signalen (S1', S2') korrespondierend zu einem detektierten Fehlerstrom in der Kommutierungselektronik,
**dadurch gekennzeichnet, dass** anschließend der folgende Schritt erfolgt:
d. Absenken der Zwischenkreisspannung, so dass das Signals S_{DIFF} eine Kurvenform erfährt, die von einem FI-Schutzschalter (8) des Typs A als Fehlerstrom erfasst werden kann oder erfasst wird, sofern der Fehlerstrom oberhalb eines maximal zulässigen Schwellenwertes liegt.

9. Verfahren gemäß Anspruch 8, **dadurch gekennzeichnet, dass** die Zwischenkreisspannung durch das Abschalten der aktiven Leistungsfaktorkorrektur abgesenkt wird, so dass das Signals S_{DIFF} einen Abschaltprozess initiiert oder von einem FI-Schutzschalter (8) des Typs A detektierbar ist.

10. Verfahren gemäß Anspruch 8 oder 9, wobei mittels des aktiven Absenkens der Zwischenkreisspannung der Spannungsverlauf zwischen der Zwischenkreisspannung und dem Massepotential eine Kurvenform erfährt, die eine Fehlerstromkurve erzeugt, die von einem FI-Schutzschalter (8) des Typs A als Fehlerstrom erfasst werden kann oder erfasst wird.

## Claims

1. EC motor (20) having a regulated DC intermediate circuit (2) consisting of a rectifier, an intermediate circuit capacitor and an inverter and commutation electronics having an active power factor correction (22) for detecting fault currents in the DC intermediate circuit (2), the DC intermediate circuit (2) having two input-side current-carrying conductors (4a, 4b), comprising:
a. a detection device (3) for detecting signals (S1, S2), each of which are proportional to the currents flowing through the two input side current-carrying conductors (4a, 4b),
b. a transformer (5) for generating in each case an analog signal S2') from the respectively detected signals (S1, S2),
c. a differential amplifier (6), which is connected to the detection device (3) in such a way that the analog signals (S1', S2') are supplied to the differential amplifier (6) as input signals, for conditioning a signal SDIFF as a differential signal between the signals S2') corresponding to a detected fault current in the commutation electronics,
d. **characterized in that** a circuit arrangement (7) is arranged between the active power factor correction (22) and the detection means (3) for lowering the DC link voltage so that the signal SDIFF can be detected by an protective switch (8) of type A for disconnection.

2. The EC motor (20) according to Claim 1, **characterized in that** the circuit configuration (7) is formed in such a way that the lowering of the DC link voltage takes place by switching off the active power factor correction.

3. The EC motor (20) according to Claim 1 or 2, **characterized in that** the DC intermediate circuit (2) is formed for generating a boosted intermediate circuit voltage.

4. The EC motor (20) according to one of the preceding claims, **characterized in that** the detection device (3) includes one electrical component (3a, 3b) in each of the two input side current-carrying conductors (4a, 4b) for tapping current signals (I_{feed}, Iᵣₑₜᵤᵣₙ).

5. The EC motor (20) according to Claim 4, **characterized in that** the two electrical components (3a, 3b) in pairs represent resistances, inductances or magnetic field sensors.

6. The EC motor (20) according to one of the preceding claims, **characterized in that** the differential amplifier (6) comprises a signal preparation module, in order to prepare the signal S_{DIFF} so that it is further processable by a microcontroller, an ASIC or an integrated circuit.

7. The EC motor (20) according to one of the preceding claims, **characterized in that** the circuit configuration (7) has a microcontroller, an ASIC or an integrated circuit for processing the signal S_{DIFF}.

8. A method for detecting fault currents according to a device according to one of Claims 1 through 7, wherein
a. Detecting two signals (S1, S2), each proportional to the currents flowing through the two input side current-carrying conductors (4a, 4b) during operation of the device, by a detection device (3),
b. Generating an analog signal S2') respectively from the detected signals (S1, S2),
c. supplying the analog signals (S1', S2') to the differential amplifier (6), which is connected to the detection device (3) in such a way that the analog signals (S1', S2') are supplied to the differential amplifier (6) as input signals, for processing a signal SDIFF as a difference signal between the signals S2') corresponding to a detected fault current in the commutation electronics,
**characterized in that** the following step is subsequently performed:
d. Lowering the DC link voltage so that the signal SDIFF has a waveform which can be detected as a fault current by a type A FI-circuit breaker (8) or is detected if the fault current is above a maximum permissible threshold value.

9. The method according to claim 8, **characterized in that** the intermediate circuit voltage is lowered by switching off the active power factor correction so that the signal SDIFF initiates a switch-off process or is detectable by a type A FI-circuit breaker (8).

10. The method according to Claim 8 or 9, wherein, by means of the active lowering of the intermediate circuit voltage, the voltage curve between the intermediate circuit voltage and the ground potential describes a wave form which generates a fault current curve, which is detectable or is detected by an type-A FI circuit breaker (8) as a fault current.

## Revendications

1. Moteur à commutation électronique (EC) (20), comprenant un circuit intermédiaire à tension continue régulée (2) composé d'un redresseur, d'un condensateur de circuit intermédiaire et d'un onduleur et d'une électronique de commutation dotée d'un dispositif de correction de facteur de puissance active (22) destiné à identifier des courants de défaut dans le circuit intermédiaire à tension continue (2), le circuit intermédiaire à tension continue (2) présentant deux fils conducteurs côté entrée (4a, 4b), comprenant :
a. un dispositif d'identification (3) pour identifier des signaux (S1, S2) qui sont respectivement proportionnels aux courants passant par les deux fils conducteurs côté entrée (4a, 4b),
b. un convertisseur (5) pour générer respectivement un signal analogique S2') à partir des signaux (S1, S2) respectivement identifiés,
c. un amplificateur différentiel (6) qui est relié au dispositif d'identification (3) de telle sorte que les signaux analogiques (S1', S2') sont amenés à l'amplificateur différentiel (6) sous forme de signaux d'entrée afin de mettre en forme un signal S_{DIFF} comme signal différentiel entre les signaux (S1', S2') en correspondance avec un courant de défaut identifié dans l'électronique de commutation,
d. **caractérisé en ce qu'**un agencement de circuit (7) est disposé entre le dispositif de correction de facteur de puissance active (22) et le dispositif d'identification (3) pour baisser la tension de circuit intermédiaire de sorte que le signal S_{DIFF} peut être identifié par un disjoncteur différentiel FI (8) de type A pour la déconnexion.

2. Moteur EC (20) selon la revendication 1, **caractérisé en ce que** l'agencement de circuit (7) est réalisé de telle sorte que la baisse de la tension de circuit intermédiaire est effectuée par la déconnexion du dispositif de correction de facteur de puissance active.

3. Moteur EC (20) selon la revendication 1 ou 2, **caractérisé en ce que** le circuit intermédiaire à tension continue (2) est réalisé pour générer une tension de circuit intermédiaire survoltée.

4. Moteur EC (20) selon l'une quelconque des revendications précédentes, **caractérisé en ce que** le dispositif d'identification (3) présente respectivement un composant électrique (3a, 3b) dans chacun des deux fils conducteurs (4a, 4b) pour prélever des signaux de courant (I_{zu}, I_{rück}).

5. Moteur EC (20) selon la revendication 4, **caractérisé en ce que** les deux composants électriques (3a, 3b) représentent par paires des résistances, des inductances ou des capteurs de champ magnétique.

6. Moteur EC (20) selon l'une quelconque des revendications précédentes, **caractérisé en ce que** l'amplificateur différentiel (6) comprend un module de mise en forme de signal pour mettre en forme le signal S_{DIFF} de telle sorte qu'il peut être traité ultérieurement par un microcontrôleur, un ASIC ou un circuit intégré.

7. Moteur EC (20) selon l'une quelconque des revendications précédentes, **caractérisé en ce que** l'agencement de circuit (7) présente un microcontrôleur, un ASIC ou un circuit intégré pour le traitement du signal S_{DIFF}.

8. Procédé d'identification de courants de défaut par un moteur EC (20) selon l'une quelconque des revendications 1 à 7, comprenant les étapes consistant à
a. identifier deux signaux (S1, S2) qui sont respectivement proportionnels aux courants passant par les deux fils conducteurs côté entrée (4a, 4b) en cours de fonctionnement du dispositif,
b. générer respectivement un signal analogique (S1', S2') à partir des signaux (S1, S2) identifiés,
c. amener les signaux analogiques (S1', S2') à l'amplificateur différentiel (6) qui est relié au dispositif d'identification (3) de telle sorte que les signaux analogiques (S1', S2') sont amenés à l'amplificateur différentiel (6) sous forme de signaux d'entrée pour mettre en forme un signal S_{DIFF} comme signal différentiel entre les signaux (S1', S2') en correspondance avec un courant de défaut détecté dans l'électronique de commutation,
**caractérisé en ce qu'**ensuite l'étape suivante est effectuée :
d. baisser la tension de circuit intermédiaire de sorte que le signal S_{DIFF} adopte une forme de courbe qui peut être ou est identifiée par un disjoncteur différentiel FI (8) de type A comme un courant de défaut dans la mesure où le courant de défaut se situe au-dessus d'une valeur seuil admissible au maximum.

9. Procédé selon la revendication 8, **caractérisé en ce que** la tension de circuit intermédiaire est baissée par la désactivation du dispositif de correction de facteur de puissance active de sorte que le signal S_{DIFF} déclenche un processus de désactivation ou peut être détecté par un disjoncteur différentiel FI (8) de type A.

10. Procédé selon la revendication 8 ou 9, dans lequel le fait de baisser activement la tension de circuit intermédiaire confère à la courbe de tension entre la tension de circuit intermédiaire et le potentiel de masse une forme de courbe qui génère une courbe de courant de défaut qui peut être ou est identifiée par un disjoncteur différentiel FI (8) de type A.
